# EUROPEAN PATENT APPLICATION

(11) **EP 1 783 829 A1**
(43) Date of publication of application: **09.05.2007**
(21) Application number: 05405617.1
(22) Date of filing: 02.11.2005
(51) Int. Cl.: H01L 21/60, H01L 21/603, H01L 23/488, H01L 23/492

(54) **Method for bonding electronic components**

(71) Applicant: ABB RESEARCH LTD., 8050 Zürich (CH)
(72) Inventor: Gunturi, Satish, 5404 Baden (CH); Zehringer, Raymond, 4132 Muttenz (CH); Knapp, Wolfgang, 5600 Lenzburg (CH)
(74) Representative: ABB Patent Attorneys

(57) **Abstract**

A first electronic component (1), in particular a semiconductor die and a second electronic component (2), in particular a substrate, each with a main surface, are bonded to each other by applying at least one metal layer (3,3') on each of the main surfaces. Then the semiconductor die and the substrate are aligned against each other with their main surfaces facing each other. The die and substrate with the metal layers (3,3') in between form an arrangement, which is introduced into a compression means. Afterwards the arrangement is compressed in the compression means at a pressure in a range of 10 to 35 MPa, and heat in a range of 230 to 275 °C is applied to the arrangement, by which temperature and pressure the electronic components (1,2) are bonded to each other. In particular the at least one metal layer may comprise silver and/or indium and the temperature and pressure used for bonding result in a reduced bonding time and allow bonding to be performed in ambient air atmosphere without oxidation of the indium.

## Description

### Field of the Invention

The present invention relates to the field of power electronics. It relates in particular to a method for bonding electronic components.

### Background of the Invention

In the document (Silver-Indium joints produced at low temperature for high temperature devices by Chuang et al., IEEE Transactions on components and packaging technologies vol. 25, 2002, p. 453 - 458) a method is described for bonding a silicon die to a silicon substrate. On the silicon die and silicon substrate multilayer films are introduced by evaporation in a thermal evaporation chamber at a vacuum of about 0.1 mPa. On the substrate first a 0.03 µm chromium layer is introduced to improve the joint adhesion, then a 0.05 µm gold layer, followed by a 5.0 µm silver layer and on top of it a 0.06 µm gold layer are evaporated. The silver layer on the silicon die is used as a protection layer for the indium layer below. On the silicon die a 0.025 µm chromium layer is introduced, followed by a 1.9 µm indium layer and then a 0.21 µm silver layer. The die and substrate are aligned against each other with the metal layers facing each other. Afterwards a static pressure of 0.5 MPa is applied to the arrangement of the die and the substrate with the multi structure layers in between in order to ensure an intimate contact between the die and the substrate. This arrangement is introduced into a tube furnace. First the furnace is filled with nitrogen, followed by hydrogen to purge the arrangement from oxygen. Then, the furnace is heated to a temperature of 206 °C for 7 min in a hydrogen atmosphere to inhibit indium oxidation at the enhanced temperature, because the silver layer alone is not sufficient for a protection against indium oxidation under these ambient conditions. Afterwards the temperature is reduced to an annealing temperature below 145 °C for 26 h. The silver-indium joint converts to a silver rich silver-indium alloy, resulting in a melting temperature of the joint of 765 to 780 °C. Such joints are nearly void-free. However, the method is complex in that it involves the need of inert gas atmosphere and the necessity to use a furnace which is intended for operation with inert gas inside the furnace. Furthermore, the high pressure required to get an intimate contact is usually achieved by a clamped load, which needs very precise machine tolerances, because otherwise voids and incomplete bonding will be the result. High-precision fixtures are used to align the multi structure layers between the die and the substrate against each other. If the silicon die or the substrate do not have a planar surface it is difficult to apply the required pressure to the arrangement without getting cracks in the components.

In the document (A fluxless process of producing tin-rich gold-tin joints in air by Chuang et al., IEEE Transactions on components and packaging technologies vol. 27, 2004, p. 177 - 181) a method is described for bonding a silicon wafer to a silicon substrate with a tin-gold joint. The silicon wafer has a chromium metallization followed by a gold metallization, whereas the silicon substrate has first a chromium metallization, followed by a tin and above a tin-gold metallization. The substrate and wafer with the metal layers in between are compressed with a pressure of about 0.6 MPa. This arrangement is inserted into a furnace maintained at 1000 °C. The temperature at the metal layers is measured. When reaching a bonding temperature of 220 °C at the metal layers, which needs about 30 s, the arrangement is cooled down. As the heat has to penetrate through the substrate and wafer, in order to get to the metal layers, the substrate and wafer are heated to very high temperatures in this method. The high temperature, at which the furnace is maintained, is necessary to achieve a very high ramp rate and thus a short bonding time. This method is not very practible, because the sensitive electronic components are heated to a much higher temperatures than the bonding temperature. Even small variances of the measuring point, a time delay between the temperature measurement and the begin of the cooling step or variations of the thicknesses of the electronic components and /or metal layers have a great influence on the local bonding temperature, so that the probability of having an inhomogeneous heat distribution, which can lead to inhomogeneous melting and bonds with voids is very high.

### Description of the Invention

It is an object of the invention to provide a reliable and robust method for bonding electronic components, which is easy to perform and to avoid the necessity to perform the bonding process in inert gas atmosphere.

This object is achieved by a method for bonding electronic components according to claim 1.

In the method for bonding electronic components according to the invention a first electronic component, in particular a semiconductor die, and a second electronic component, in particular a substrate, are attached to each other in a bonding process. Each of the electronic components have a main surface. The method comprises following steps:
- at least one metal layer is applied on each of the main surfaces of said electronic components,
- the first and second electronic components are aligned against each other with their main surfaces facing each other, the first and the second electronic components with the metal layers in between forming an arrangement, and
- the arrangement is introduced into a compression means.

The method is characterized in that the arrangement is compressed at a pressure in a range of 10 to 35 MPa, and heat in a range of 230 to 275°C is applied to the arrangement.

At such a high temperature and such a high pressure the bonding process, comprising the steps of heating and compressing, can be performed without the necessity to perform the process in inert gas atmosphere. Due to the high temperature and high pressure, the time for the heating and compression process is shortened and the metal layers form a stable joint before an oxidation of the indium layer can occur. The bonding method can be performed in ambient air atmosphere, i.e. more generally an oxygenous gas atmosphere, so that no sophisticated bonding apparatuses, which have to be operated with inert gas atmosphere inside, are needed, but a standard bonding apparatus with ambient air atmosphere inside can be used. Thus a robust method is provided, which results in firm and nearly void-free solder joints. Different kind of materials can be bonded, as long as they can be metallized and if they can withstand the necessary temperature and pressure during the bonding process. No parts of the arrangement are heated beyond the temperature, which is applied to the arrangement and which temperature corresponds to the bonding temperature.

In a preferred embodiment at least one of the electronic components is protected by an elastically deformable protection layer on the side opposite to the main surface of at least one electronic component prior to being compressed. Advantageously, the protection layer comprises rubber, which is a soft material and has good elastical and compression properties. Such a protection layer is inexpensive and does not have to be preformed according to the outer form of the arrangement. As the elastical deformable protection layer adapts itself to the outer form of the arrangement, the danger of cracks is reduced and even variations in the outer form of the arrangement can be compensated.

Further advantages according to the present invention will be apparent from the dependent claims.

### Brief Description of the Drawings

The subject matter of the invention will be explained in more detail in the following text with reference to the attached drawings, in which:
- FIG. 1: shows a first realization of the method for bonding electronic components according to the invention;
- FIG. 2: shows a further realization of the method for bonding electronic components according to the invention prior to the compression process;
- FIG. 3: shows the realization of FIG. 2 in compressed condition; and
- FIG. 4: shows a further realization of the method for bonding electronic components according to the invention.

Generally, alike or alike-functioning parts are given the same reference symbols. The described realizations are meant as examples and shall not confine the invention.

### Detailed Description of Preferred Embodiments

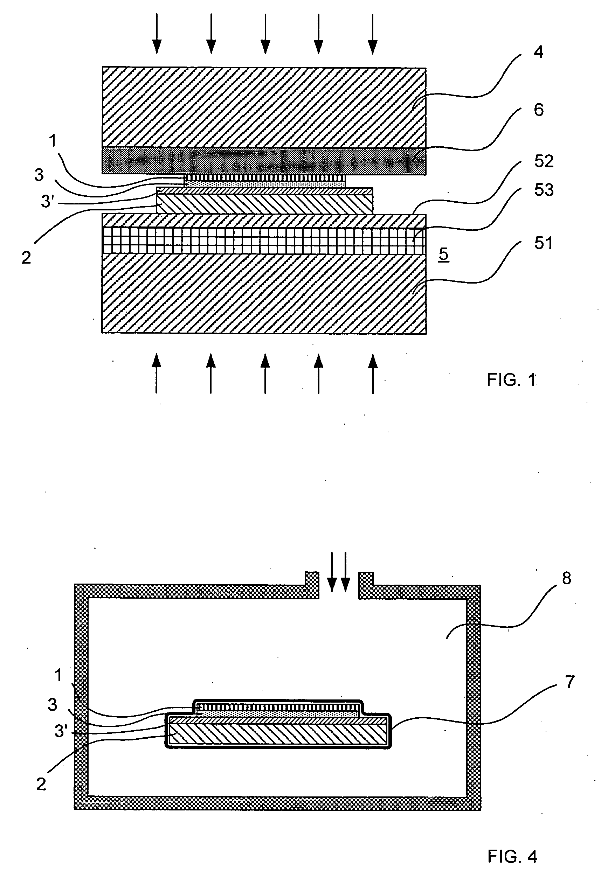

FIG. 1 shows a first realization of the inventive method. A first electronic component 1 has a main surface, on which at least one metal layer 3 is applied, in particular a chromium layer adjacent to the main surface of the first electronic component, followed by an indium layer and on top of it a silver layer. A second electronic component 2 has a main surface, on which at least one metal layer 3' is applied, in particular a chromium layer adjacent to the main surface of the second electronic component, followed by a gold, silver and another gold layer. The chromium layer improves the adhesion of the joint. The first and/or second electronic components 1, 2 can be made of any material that can be metallized, e.g. by evaporation or sputtering and that can withstand the applied temperature and pressure during the bonding process. Such electronic components are typically a semiconductor die, a substrate, a metal layer, a silicon layer, a metallized composite material or a metal matrix material.

The metal layers 3, 3' are applied to the electronic components 1, 2 by placing the first electronic component 1 in a thermal evaporation chamber and then evaporating at least one metal layer 3 on the main surface of the first electronic component 1. The second electronic component 2 is then placed in the thermal evaporation chamber and at least one metal layer 3' is evaporated on the main surface of the second electronic component 2. Alternatively, the metal layers 3, 3' can be sputtered on the main surfaces of the electronic components 1, 2.

It is also possible to exchange the at least one metal layer 3 arranged on the main surface of the first electronic component 1 with the at least one metal layer 3' arranged on the main surface of the second electronic component 2. It is also possible to use other metal layers 3, 3' in order to form the joint.

In the realization of the inventive method shown in FIG. 1 the first and second electronic component 1, 2 are aligned against each other with the main surfaces of the first and second electronic component facing each other and the metal layers 3, 3' being arranged between the electronic components 1, 2. This arrangement is introduced between the top and bottom platens 4, 5 of a compression press or compression clamp with an elastically deformable protection layer 6 either positioned between the first electronic component 1 and the top platen 4 and/or an elastically deformable protection layer 6' positioned between the second electronic component 2 and the bottom platen 5. Thereby, the electronic component 1 and/or 2 are protected during the compression process. The bottom platen, as shown in FIG. 1, comprises a platen 51 and a platen 52 with a hot plate 53 sandwiched between the two platens 51 and 52. The platen 52 is constructed in such a way that the heat can be easily transmitted from the hot plate 53 through the platen 52 to the arrangement so that the metal layers in the arrangement are heated up. By arranging the hot plate 53 between two platens 51 and 52 the heat is homogeneously distributed, resulting in a uniform heating up of the arrangement. The bottom platen 5 may also be constructed as one platen with a hot plate 53 on top of it so that the platen is of simple construction. Similarly the hotplate could also be arranged in the top platen for the purpose of heating the arrangement.

Afterwards the arrangement is compressed by a static pressure in the range of 10 to 35 MPa. In a preferred realization a pressure in the range of 30 to 35 MPa is applied. Such a high pressure ensures a good contact over the whole area between the metal layers 3, 3' of the first and second electronic components 1, 2. Afterwards the arrangement is heated up by heating the hot plate 53. The heat penetrates through the platen 52 and is transmitted to the metal layers 3, 3' on the main surfaces of the first and second electronic components 1, 2 which are bonded by the heating. This heating process is performed at a temperature between 230 to 275 °C, in a preferred realization heat in a range between 230 to 250 °C is applied to the arrangement. If the temperature is too low, the bonding process would take longer and thereby the probability of oxidation of the indium layer would increase. Also at low temperatures inhomogeneous heat distribution can lead to inhomogeneous melting and bonds with voids. If the temperature was too high, it could result in an irregular and poor bonding joint because of squeezing out of molten metal layers and resulting in an oxidation of the indium layer.

The heat is applied to the arrangement for a period of 3 to 5 min, the heating time period depending on the applied temperature and the size and thickness of the electronic components 1, 2 and metal layers 3, 3'. Afterwards the arrangement is cooled down to ambient temperature. The heating over such a short period, in connection with the high pressure and high temperature leads to a nearly void-free silver-indium joint without the danger of oxidation of the indium layer, even if the bonding process, i.e. the compression process and heating process, is performed in ambient air atmosphere.

In a preferred realization, not shown in a figure, the arrangement is introduced into a preform with the relative positions of the components of the arrangement predetermined by one or more alignment means prior to the compression and heating process. Such a preform helps to avoid unintentional displacements of the components, especially lateral displacements. The preform may either be made of a stiff or an elastically deformable material. If the preform is made of a stiff material, the preform can be constructed very accurately, so that the relative positions of the components 1, 2 are very well defined, when they are introduced into the preform. If the preform is made of a elastically deformable material, expansions due to the raised temperature, deviations or inaccuracies of the form of the components can be compensated. The preform may also comprise a bottom and / or top layer, preferably of an elastically deformable material like rubber, so that the different parts of the arrangement are protected against lateral displacement and against cracks in the components, which may be caused by the pressure applied during the bonding process.

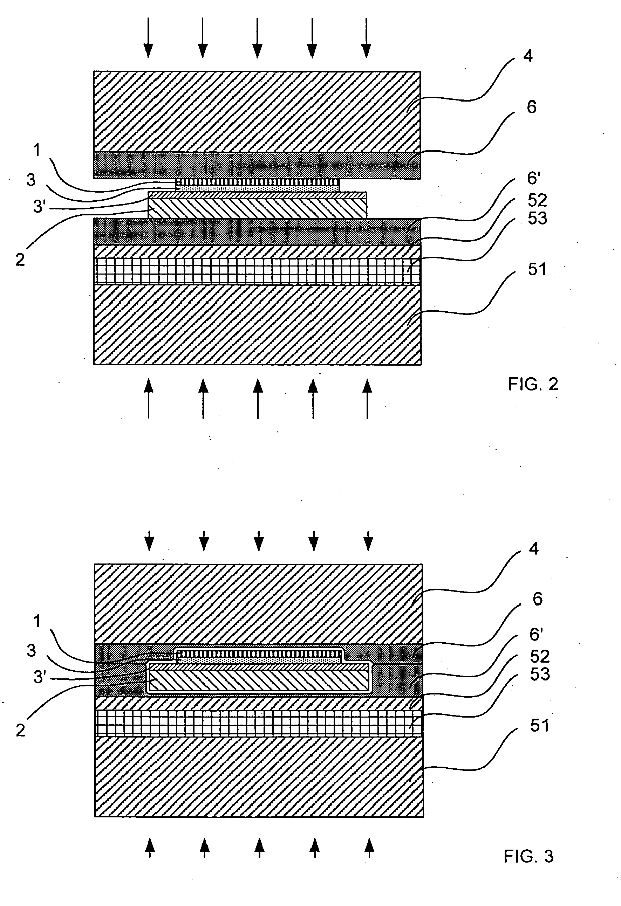

FIG. 2 and 3 show another realization of the inventive method. In FIG. 2 the arrangement with the electronic components 1, 2 is protected by two elastically deformable protection layers 6, 6', which are arranged on the sides opposite of the main surfaces of the electronic components 1, 2. The arrangement is introduced into a compression press or compression clamp. FIG. 2 shows the arrangement and protection layers 6, 6' in uncompressed condition, depicted by long arrows pointing to the platens 4, 5 of the compression press or compression clamp respectively. FIG. 3 shows the arrangement and protection layers 6, 6' in compressed condition, depicted by short arrows. In a preferred embodiment, the two protection layers 6, 6' touch each other in compressed condition and form a closed packaging. Air remaining between the arrangement and the protection layers 6, 6' in compressed condition is also compressed and forms a fluid compression means, thereby improving the compression of the arrangement.

Instead of using at least one plain protection layer 6, 6' the at least one protection layer 6, 6' may also be preformed with a recess, in which the arrangement can be positioned to apply a more uniform pressure to all parts of the arrangement during the bonding process and also to avoid lateral displacements of the parts of the arrangement, i.e. to avoid displacements between any of the electronic components 1, 2 and / or any of the metal layers 3, 3'. If two protection layers 6, 6' are used, these layers can also be one common protection layer, which is laid around the arrangement in a u-shaped form, or a common protection bag, which is open to one side, at which side the arrangement can be introduced.

If two separate protection layers 6, 6' are used, which embed the arrangement from two opposite sides, the thickness and elasticity of the protection layers 6, 6' can be chosen in such a way that in a compressed stage the protection layers 6, 6' touch each other (as shown in Fig. 3), thereby limiting the maximum pressure which can be applied to the arrangement, thus reducing the danger of cracks.

FIG. 4 shows a further realization of the inventive method. Fig. 4 shows the arrangement and protection layers in compressed condition, depicted by arrows. The arrangement is protected by an elastically deformable protection layer, in FIG. 4 this protection layer has the form of a packaging 7, which protects the arrangement at least from two opposite sides, which sides are the sides opposite the main surfaces of the electronic components, prior to the compression process. The packaging 7 may for instance be made of rubber or any other material, which is capable of withstanding the bonding temperature and pressure. The packaging 7 with the inserted arrangement is introduced into a compression chamber 8 of an isostatic press. The packaging 7 with the inserted arrangement is compressed in the compression chamber by means of compressed air at raised temperature depicted by arrows in FIG. 4. It is also possible to compress the arrangement by means of other fluids (gas or liquid). The fluid results in a uniform pressure on the arrangement, without the risk of mechanical stresses, which could lead to cracks in the electronic components 1, 2. In addition, prior to introducing the arrangement into the packaging 7 the arrangement can be introduced into a preform with the relative positions of the components of the arrangement predetermined by one or more alignment means prior to the compression and heating process. It is also possible to insert the arrangement into a plastic cover and to seal the plastic cover in order to avoid that fluid, except for ambient air, directly comes in contact with the arrangement.

### List of Designations

- 1: first electronic component
- 2: second electronic component
- 3, 3': metal layer
- 4: top platen
- 5: bottom platen
- 51, 52: platen
- 53: hot plate
- 6, 6': protection layer
- 7: elasically deformable packaging
- 8: compression chamber

## Claims

1. Method for bonding electronic components,
in which a first electronic component (1), in particular a semiconductor die, and a second electronic component (2), in particular a substrate, are fixed to each other in a bonding process, each of the electronic components (1, 2) having a main surface, and the method comprising the following steps:
- at least one metal layer (3, 3') is applied on each of the main surfaces of said electronic components (1, 2),
- the first and second electronic components (1, 2) are aligned against each other with their main surfaces facing each other, the first and the second electronic components (1, 2) together with the metal layers in between forming an arrangement, and
- the arrangement is introduced into a compression means,
**characterized in that**
- the arrangement is compressed at a pressure in a range of 10 to 35 MPa, and
- heat in a range of 230 to 275°C is applied to the arrangement.

2. Method according to claim 1, **characterized in that**
the compression means is operated with ambient air atmosphere inside the compression means.

3. Method according to claim 1 or 2, **characterized in that**
the arrangement is compressed at a pressure in a range of 30 to 35 MPa and /or **in that** the heat applied to the arrangement is in a range of 230 to 250°C.

4. Method according to any of the claims 1 to 3, **characterized in that**
the heating process is performed for a period of 3 to 5 min.

5. Method according to any of the claims 1 to 4, **characterized in that**
the at least one metal layer (3, 3') comprises a silver and/or an indium layer.

6. Method according to claim 1 or 5, **characterized in that**
the metal layers are applied on the main surfaces of the electronic components by sputtering or evaporation.

7. Method according to any of the preceding claims, **characterized in that**
at least one of the electronic components (1, 2) is protected by an elastically deformable protection layer (6, 6') on the side opposite of the main surface of the at least one electronic component (3, 3'), in particular a protection layer (6, 6') comprising rubber, prior to being compressed.

8. Method according to any of the preceding claims, **characterized in that**
the compression means is a compression press, in particular a compression clamp or a compression chamber of an isostatic press.

9. Method according to any of the preceding claims, **characterized in that**
the arrangement is inserted into a preform, which comprises one or several means for alignment, and the relative positions of the first and second electronic components (1, 2) are predetermined by the one or several means for alignment.

10. Method according to claim 1, **characterized in that**
the electronic components comprise layers of silicon, metal, metallized ceramic composite material and / or a metal matrix material.
